# FASCICULE DE BREVET EUROPEEN

(11) **EP 3 822 698 B1**
(45) Date de publication et mention de la délivrance du brevet: **12.01.2022**
(21) Numéro de dépôt: 20204476.4
(22) Date de dépôt: 28.10.2020
(51) Int. Cl.: G02F 1/025

(54) **TRANSMETTEUR PHOTONIQUE**
PHOTONISCHER SENDER
PHOTONIC TRANSMITTER

(30) Priorité: 18.11.2019 FR 1912820
(43) Date de publication de la demande: 19.05.2021
(73) Titulaire: Commissariat à l'Energie Atomique et aux Energies Alternatives, 75015 Paris (FR)
(72) Inventeur: HASSAN, Karim, 38054 GRENOBLE Cedex 09 (FR); DESIERES, Yohan, 38054 GRENOBLE Cedex 09 (FR)
(74) Mandataire: INNOV-GROUP

(56) Documents cités:
- EP-A1- 3 206 079
- EP-B1- 3 206 079
- FR-A1- 3 054 926
- HELENE DUPREZ ET AL: "1310 nm hybrid InP/InGaAsP on silicon distributed feedback laser with high side-mode suppression ratio", OPTICS EXPRESS, vol. 23, no. 7, 25 mars 2015 (2015-03-25), page 8489, XP055197550, DOI: 10.1364/OE.23.008489
- PO DONG ET AL: "Novel integration technique for silicon/III-V hybrid laser", OPTICS EXPRESS, vol. 22, no. 22, 21 octobre 2014 (2014-10-21), page 26854, XP055424657, DOI: 10.1364/OE.22.026854

## Description

L'invention concerne un transmetteur photonique comportant une source laser et un modulateur. L'invention a également pour objet un procédé de fabrication de ce transmetteur.

Des transmetteurs photoniques connus comportent :
- une source laser à semi-conducteur apte à générer un signal optique, et
- un modulateur de phase réalisé sur le même substrat et apte à moduler le signal optique généré par la source laser à semi-conducteur.

Un tel transmetteur est par exemple divulgué dans la demande US2017237229A1 ou FR3054926A1. Le transmetteur divulgué dans cette demande est avantageux en ce qu'il implémente un modulateur électro-optique connu sous l'acronyme EOM (« Electro-Optic Modulator ») et, plus précisément, un modulateur capacitif hybride. Les modulateurs capacitifs présentent une bande passante optique bien plus grande que les modulateurs à électro-absorption ou EAM (« Electro-absorption Modulator »). La bande passante optique d'un modulateur est la gamme de longueur d'onde sur laquelle ce modulateur peut fonctionner.

Pour réaliser un modulateur capacitif, il faut un bon couplage capacitif entre l'électrode inférieure et l'électrode supérieure du modulateur. Cela impose que l'épaisseur de la couche diélectrique qui sépare ces deux électrodes soit très fine, c'est-à-dire que son épaisseur soit comprise entre 5 nm et 35 nm.

L'invention décrite ici vise à proposer un transmetteur présentant les mêmes avantages que celui de la demande US2017237229A1 tout en étant plus simple à fabriquer.

Elle a donc pour objet un tel transmetteur photonique conforme à la revendication 1.

L'invention a également pour objet un procédé de fabrication du transmetteur photonique ci-dessus.

L'invention sera mieux comprise à la lecture de la description qui va suivre, donnée uniquement à titre d'exemple non limitatif et faite en se référant aux dessins sur lesquels :
- la figure 1 est une illustration schématique d'un transmetteur en coupe verticale ;
- la figure 2 est un organigramme d'un procédé de fabrication du transmetteur de la figure 1 ;
- les figures 3 à 11 sont des illustrations schématiques, en coupe verticale, de différents états de fabrication obtenus lors de la mise en œuvre du procédé de la figure 2.

Dans ces figures, les mêmes références sont utilisées pour désigner les mêmes éléments. Dans la suite de cette description, les caractéristiques et fonctions bien connues de l'homme du métier ne sont pas décrites en détail.

Dans cette description des exemples détaillés de modes de réalisation sont d'abord décrits dans le chapitre I en référence aux figures. Ensuite, dans le chapitre II suivant, des variantes de ces modes de réalisation sont présentées. Enfin, les avantages des différents modes de réalisation sont présentés dans un chapitre III.

### Chapitre I : Exemples de modes de réalisation

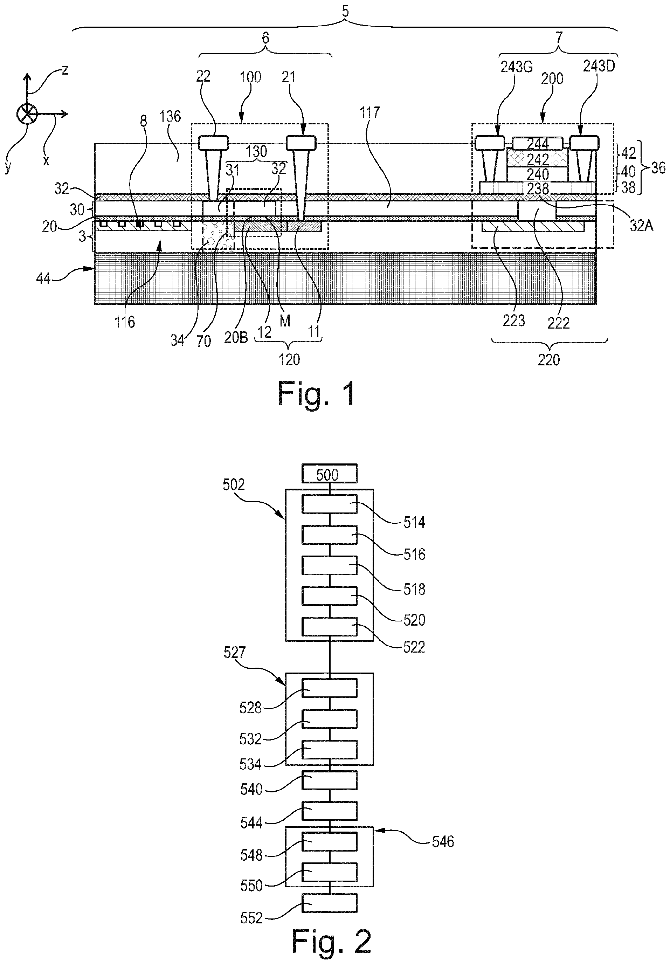

La figure 1 représente un transmetteur 5 d'un signal optique modulé en phase et/ou en amplitude pour transmettre des bits d'informations vers un récepteur par l'intermédiaire d'une fibre optique par exemple. A cet effet, le transmetteur 5 comporte une source laser 7 qui émet un signal optique dont la phase et/ou l'amplitude est ensuite modulée par un système 6 de modulation de phase et/ou d'amplitude de ce signal optique. Par exemple, la longueur d'onde λ_{Li} du signal optique émis par la source laser 7 est comprise entre 1240 nm et 1630 nm.

La figure 1 représente les éléments du transmetteur 5 en coupe dans un plan vertical parallèle aux directions X et Z.

Sur la figure 1 et les figures suivantes, l'horizontal est représenté par des directions X et Y d'un repère orthogonal. La direction Z de ce repère orthogonal représente la direction verticale. Par la suite, les termes tels que « supérieur », « inférieur », « au-dessus », « en dessous », « haut » et « bas » sont définis par rapport à cette direction Z. Les termes « gauche » et « droite » sont définis par rapport à la direction X. Les termes « avant » et « arrière » sont définis par rapport à la direction Y.

Par la suite, le terme "épaisseur" désigne l'épaisseur maximale d'un élément dans la direction Z.

Le système 6 peut être un système de modulation de la phase seule, ou de l'amplitude seule ou simultanément de la phase et de l'amplitude.

Pour moduler la phase ou l'amplitude du signal optique, le système 6 comporte au moins un modulateur de phase et, souvent, au moins un dispositif d'accord de phase. Par exemple, le système 6 est un interféromètre de Mach-Zehnder dans lequel le modulateur et le dispositif d'accord de phase sont agencés dans l'une des branches de cet interféromètre pour moduler l'amplitude et/ou la phase du signal optique généré par la source laser 7. Les structures d'un interféromètre de Mach-Zehnder et d'un dispositif d'accord de phase sont bien connues et ne sont pas décrites ici en détail. Le dispositif d'accord de phase est par exemple le même que celui décrit dans la demande US2017237229A1. Par conséquent, pour simplifier la figure 1, seul un modulateur 100 de phase est représenté.

Le modulateur 100 permet de modifier rapidement la phase du signal optique. A cet effet, le modulateur 100 est ici un modulateur électro-optique connu sous l'acronyme EOM (« Electro-Optic Modulator ») et, plus précisément, un modulateur capacitif hybride. Il comporte donc deux électrodes 120 et 130 situées en vis-à-vis l'une de l'autre et formant un condensateur.

L'électrode 120 est en silicium monocristallin dopé. Dans ce mode de réalisation, elle est entièrement structurée dans le silicium monocristallin d'une couche 3.

La couche 3 comporte du silicium monocristallin encapsulé dans un matériau diélectrique 116. Généralement, un matériau diélectrique a une conductivité électrique à 20 °C inférieure à 10⁻⁷S/m et, de préférence, inférieure à 10⁻⁹S/m ou 10⁻¹⁵S/m. De plus, dans le cas du matériau diélectrique 116, son indice de réfraction est strictement inférieur à l'indice de réfraction du silicium. Par exemple, dans ce mode de réalisation, le matériau diélectrique 116 est du dioxyde de silicium (SiO₂). La couche 3 s'étend principalement dans un plan horizontal. La couche 3 est directement située sur un substrat rigide 44.

Le substrat 44 s'étend horizontalement dans un plan appelé « plan du substrat ». Dans cet exemple de réalisation, le substrat 44 est un support dont l'épaisseur est typiquement supérieure à 200 µm ou 400 µm. Par exemple, substrat 4 est un support en silicium de 725µm.

Dans la couche 3, le silicium monocristallin s'étend verticalement depuis un plan inférieur horizontal jusqu'à l'interface entre la couche 3 et une couche 20 en matériau diélectrique située directement dessus la couche 3. Ce plan inférieur horizontal est situé au-dessus de l'interface entre la couche 3 et le substrat 44. Ainsi, le silicium monocristallin de la couche 3 est également isolé mécaniquement et électriquement du substrat 44 par le matériau diélectrique 116. Par exemple, l'épaisseur de silicium monocristallin dans la couche 3 est comprise entre 100 nm et 800 nm. Classiquement, l'épaisseur de silicium monocristallin est égale à 65 nm ou 150nm ou 300 nm ou 500 nm. Dans cet exemple, l'épaisseur du silicium monocristallin dans la couche 3 est égale à 300 nm.

L'électrode 120 s'étend, dans la direction X, depuis une extrémité proximale 12 jusqu'à une extrémité distale 11. Elle s'étend également dans la direction Y.

Ici, l'extrémité distale 11 est plus dopée que l'extrémité proximale 12. Par exemple, la concentration de dopant dans l'extrémité distale 11 est comprise entre 10¹⁹ et 10²¹ atomes/cm³. La concentration de dopant dans l'extrémité proximale 12 est par exemple comprise entre 10¹⁷ et 10¹⁹ atomes/cm³.

Ici, l'épaisseur e₁₂ de l'extrémité proximale 12 est égale à l'épaisseur du silicium monocristallin encapsulé dans la couche 3. Cette épaisseur e₁₂ est donc égale à 300 nm ici.

L'électrode 130 est réalisée en matériau cristallin III-V dopé avec un dopage de signe opposé à celui de l'électrode 120. La concentration en dopant de l'électrode 130 est comprise, par exemple, entre 10¹⁷ et 2 × 10¹⁸ atomes/cm³ ou entre 10¹⁷ et 2 × 10¹⁹ atomes/cm³.

L'électrode 130 s'étend, parallèlement à la direction X, depuis une extrémité proximale 32 jusqu'à une extrémité distale 31. L'électrode 130 s'étend également dans la direction Y. L'électrode 130 est directement située dessus la couche 20 en matériau diélectrique. Elle est donc séparée mécaniquement et isolée électriquement de l'électrode 120 par cette couche 20.

L'extrémité proximale 32 est située en vis-à-vis de l'extrémité proximale 12 et séparée de cette extrémité proximale 12 uniquement par une portion 20B de la couche 20 interposée entre ces extrémités proximales. Par rapport à un plan vertical parallèle aux directions Y et Z et passant par les extrémités proximales 12 et 32, l'extrémité distale 31 est située d'un côté de ce plan tandis que l'extrémité distale 11 est située de l'autre côté. Les extrémités distales 11 et 31 ne sont donc pas en vis-à-vis.

Ici, l'épaisseur e₂₀ de la couche 20, et donc l'épaisseur de la portion 20B, est choisie très fine pour obtenir un bon couplage capacitif entre les électrodes 120 et 130. A cet effet, l'épaisseur e₂₀ est comprise entre 5 nm et 35 nm. Par exemple, l'épaisseur e₂₀ est ici égale à 10 nm.

L'électrode 130 est entièrement structurée dans le matériau cristallin III-V d'une couche 30. La couche 30 est située directement sur la couche 20. Elle comporte le matériau cristallin III-V encapsulé dans un matériau diélectrique 117. Ici, le matériau cristallin III-V encapsulé dans la couche 30 est l'alliage InP. A l'intérieur de la couche 30, le matériau cristallin III-V s'étend verticalement depuis l'interface entre les couches 20 et 30 jusqu'à un plan horizontal supérieur situé, dans ce mode de réalisation, au niveau de l'interface entre la couche 30 et une couche 32 en matériau diélectrique.

Ici, l'épaisseur du matériau cristallin III-V encapsulé dans la couche 30 est égale à l'épaisseur e₃₂ de l'extrémité proximale 32 de l'électrode 130. Typiquement, l'épaisseur e₃₂ est choisie pour optimiser le ratio déphasage optique sur perte optique du modulateur 100. Pour cela, l'épaisseur e₃₂ est ici comprise entre 0,7e₁₂ et 1,3e₁₂. La valeur exacte de l'épaisseur e₃₂ est, par exemple, déterminée en simulant différentes valeurs possibles pour l'épaisseur e₃₂ afin d'identifier laquelle de ces valeurs permet d'optimiser ce ratio. Par exemple, dans le cas présent où les épaisseurs e₁₂ et e₂₀ sont égales, respectivement, à 300 nm et 10 nm, l'épaisseur e₃₂ est choisie égale à 300 nm.

La zone 34, qui s'étend verticalement depuis l'extrémité distale 31 jusqu'au substrat 44, comporte uniquement des matériaux diélectriques solides. Ici, il s'agit du matériau diélectrique 116 et du matériau diélectrique de la couche 20. Grâce à cela, la capacité parasite entre cette extrémité 31 et le substrat 44 est fortement réduite. Cette zone 34 est, par exemple, identique à celle décrite dans la demande US2017237229A1.

La superposition, dans la direction Z, de l'extrémité proximale 12, de la portion 20B de la couche 20 et de l'extrémité proximale 32 est dimensionnée pour former un guide d'onde 70, capable de guider, dans la direction Y, le signal optique généré par la source laser 7. Le guide d'onde 70 est typiquement raccordé optiquement à la source laser 7 par l'intermédiaire d'autres guides d'onde et d'autres coupleurs structurés dans la couche 3. Pour simplifier la figure 1, ces autres guides d'onde et autres coupleurs n'ont pas été représentés.

Le modulateur 100 comporte aussi deux prises de contact 21 et 22, en contact mécanique et électrique directement avec, respectivement, les extrémités distales 11 et 31. Ces prises 21 et 22 sont raccordées à une source de tension pilotable en fonction du bit ou des bits d'information à transmettre par le transmetteur 5.

Typiquement, la source laser 7 est un laser DBR (« Distributed Bragg Reflector laser ») ou DFB (« Distributed FeedBack laser »). Une telle source laser est bien connue et seuls les détails nécessaires pour la compréhension de l'invention sont décrits ici. Par exemple, pour des détails généraux et le fonctionnement d'une telle source laser, le lecteur peut se référer aux articles suivants :
- B. Ben Bakir et al., « Hybrid Si/III-V lasers with adiabatic coupling », 2011.
- B. Ben Bakir, C. Sciancalepore, A. Descos, H. Duprez, D. Bordel, L. Sanchez, C. Jany, K. Hassan, P. Brianceau, V. Carron, and S. Menezo, « Heterogeneously Integrated III-V on Silicon Lasers », Invited Talk ECS 2014.

Pour simplifier la figure 1 et les figures suivantes, seul un guide d'onde laser hybride 200, 220 de la source laser 7 et un coupleur surfacique 8 (connu sous le terme anglais de « Surface grating coupler ») sont représentés.

Un tel coupleur 8 est par exemple décrit dans l'article suivant : F. Van Laere, G. Roelkens, J. Schrauwen, D. Taillaert, P. Dumon, W. Bogaerts, D. Van Thourhout and R. Baets, « Compact grating couplers between optical fibers and Silicon-on-Insulator photonic wire waveguides with 69% coupling efficiency*".* Ici, ce coupleur 8 est entièrement structuré dans le silicium monocristallin de la couche 3.

Le guide d'onde laser hybride 200, 220 est constitué d'un guide d'onde 200 réalisé dans un matériau a gain III-V et d'un guide d'onde 220. Généralement le guide d'onde 200 est utilisé pour générer et amplifier un signal optique à l'intérieur d'une cavité optique de la source laser 7. Ici, à cet effet, il est réalisé dans une couche 36 comportant un matériau à gain III-V encapsulé dans un matériau diélectrique 136. Par exemple, le matériau 136 est du dioxyde de silicium ou du nitrure de silicium. Cette couche 36 s'étend horizontalement directement sur la couche 32 en matériau diélectrique.

La couche 36 comprend typiquement une sous-couche inférieure dopée 38, un empilement 40 de puits quantiques ou boites quantiques en quaternaire et une sous-couche supérieure 42 dopée avec un dopant de signe opposé à celui de la sous-couche 38. Les sous-couches 38 et 42 sont par exemple ici en alliage InP monocristallin dopé N ou P. Dans ce cas, l'empilement 40 est, par exemple, un empilement en alternance de sous-couches en InGaAsP ou en AlGaInAs ou autre.

Sur la figure 1, seule une bande 238, un empilement 240 et une bande 242 réalisés, respectivement, dans la sous-couche 38, l'empilement 40 et la sous-couche 42 sont représentés. Cette superposition de la bande 238, de l'empilement 240 et de la bande 242 constitue le guide d'onde 200.

Le guide d'onde 200 comporte également :
- des prises 243G et 243D de contact en contact mécanique et électrique directement avec la bande 238 et situées, respectivement, à gauche et à droite de l'empilement 240, et
- une prise 244 de contact en contact mécanique et électrique directement avec la bande 242.

Ces prises 243G, 243D et 244 permettent d'injecter un courant électrique dans le guide d'onde 200 en matériau à gain III-V entre les prises 243G, 243D et la prise 244.

Le guide d'onde 220 s'étend sous le guide d'onde 200. Il est séparé du guide d'onde 200 par la couche 32 en matériau diélectrique. Dans la figure 1, le guide d'onde 220 est représenté, à titre d'illustration, dans le cas où la direction de propagation du signal optique à l'intérieur de ce guide d'onde est parallèle à la direction Y. Dans ce mode de réalisation, le guide d'onde 220 comporte :
- une partie haute 222 réalisée au moins en partie dans la couche 30, et
- une partie basse 223 entièrement réalisée dans la couche 3.

Ici, le guide d'onde 220 adopte une conformation connue sous l'expression de "guide d'onde à arrête" ou sous le terme anglais de « RIB waveguide». Ainsi, dans la section transversale de ce guide d'onde, parallèlement au plan XZ, la partie haute 222 constitue l'arrête ("strip" en anglais) et la partie basse 223 constitue la dalle ("slab" en anglais) du guide d'onde 220.

Dans ce mode de réalisation, l'épaisseur e₂₂₃ de la partie 223 est égale à l'épaisseur e₁₂, c'est-à-dire à 300 nm.

Le guide d'onde 220 est uniquement séparé de la bande 238 par une portion 32A de la couche 32.

Le guide d'onde 220 est raccordé optiquement au guide d'onde 200 par un couplage adiabatique. Pour une description détaillée d'un couplage adiabatique le lecteur peut se référer à l'article suivant : Amnon Yariv et al., « Supermode Si/III-V hybrid Lasers, optical amplifiers and modulators: proposai and analysis » Optics Express 9147, vol. 14, No. 15, 23/07/2007.

Les caractéristiques du couplage optique entre le guide d'onde 220 et le guide d'onde 200 dépendent notamment :
- des dimensions du guide d'onde 220 et, en particulier, de l'épaisseur e₂₂₂ de la partie haute 222, et
- de l'épaisseur e_{32A} de matériau diélectrique dans la portion 32A de la couche 32 interposée entre les guides d'onde 200 et 220.

Il est donc important que les épaisseurs e₂₂₂ et e_{32A} puissent être ajustées indépendamment des dimensions des autres composants photoniques réalisés sur le même substrat 44. Ici, l'épaisseur e_{32A} est égale à l'épaisseur de la couche 32 et peut donc être ajustée indépendamment de l'épaisseur e₂₀.

Pour optimiser le fonctionnement de la source laser 7, l'épaisseur e_{32A} est supérieure à 40 nm et, typiquement, comprise entre 40 nm et 1 µm ou entre 40 nm et 500 nm ou entre 50 nm et 150 nm ou entre 50 nm et 140 nm. A titre d'illustration, ici, l'épaisseur e_{32A} est égale à 100 nm.

Avec un tel choix de l'épaisseur e_{32A}, le couplage entre les guides d'onde 200 et 220 est adiabatique. Dans ces conditions, de préférence, seul le guide d'onde 220 présente des extrémités en forme de pointe pour assurer un bon échange de puissance optique entre les guides d'onde 200 et 220. Ces formes de pointe sont connues sous le terme anglais de « tapers ».

Toujours pour optimiser le fonctionnement de la source laser 7, l'épaisseur e₂₂₂ est supérieure ou égale à 200 nm ou 300 nm. De préférence, l'épaisseur e₂₂₂ est supérieure ou égale à l'épaisseur e₃₂ de l'électrode 130. Ici, l'épaisseur e₂₂₂ est égale à e₂₀+e₃₂. Ainsi, ici, l'épaisseur e₂₂₂ est égale à 310 nm.

Un fonctionnement possible du transmetteur 5 est le suivant. La source laser 7 génère un signal optique. Au moins, une partie de ce signal optique est dirigée vers un interféromètre de Mach Zehnder dont au moins l'une des branches comporte le modulateur 100. Cette partie de signal optique est donc guidée par le guide d'onde 70 avant d'être recombinée avec une autre partie du signal optique guidée par l'autre branche de l'interféromètre de Mach Zehnder pour former le signal optique modulé.

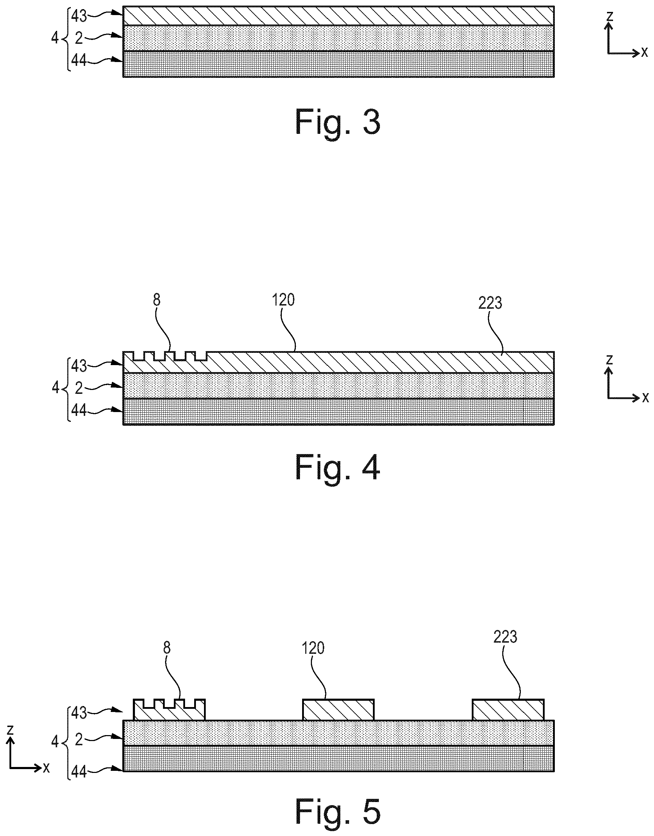

Un procédé de fabrication du transmetteur 5 va maintenant être décrit en référence aux figures 2 à 11. Les figures 3 à 11 représentent différents états de fabrication du transmetteur 5 en coupe verticale parallèlement aux directions X et Z. Pour simplifier ces figures et la description de ce procédé, les étapes et opérations classiques de fabrication des autres composants optiques que ceux représentés sur la figure 1 et nécessaires au fonctionnement du transmetteur 5, est omise.

Lors d'une étape 500, le procédé débute par la fourniture d'un substrat 4 (Figure 3). Ici, ce substrat 4 est un substrat SOI (« silicon on insulator »). Le substrat 4 comporte directement empilés les uns au-dessus des autres dans la direction Z :
- le support 44 en silicium, d'épaisseur supérieur à 400 µm ou 700 µm classiquement,
- une couche 2 enterrée en dioxyde de silicium, et
- une couche 43 en silicium monocristallin qui, à ce stade, n'a pas encore été gravée ni encapsulée dans un matériau diélectrique.

Classiquement, l'épaisseur de la couche 2 est supérieure ou égale à 75 nm ou 90 nm. Par exemple, l'épaisseur de la couche 2 est supérieure à 500 nm ou 1 µm et, généralement, inférieure à 3 µm ou 5 µm. Dans cet exemple de réalisation, l'épaisseur de la couche 2 est égale à 800 nm.

L'épaisseur de la couche 43 est ici égale à l'épaisseur e₁₂ ou e₂₂₃. Elle est donc égale à 300 nm.

Lors d'une étape 502, les couches 3 et 20 sont réalisées. Pour cela, la couche 43 est gravée pour structurer les différentes parties des composants optiques situées à l'intérieur de la couche 3. Ainsi, lors de cette étape 502, la partie basse 223 du guide d'onde 220, l'électrode 120 et le coupleur surfacique 8 sont structurés dans la couche 43 de silicium monocristallin.

Par exemple, lors d'une opération 514, la couche 43 subit une première gravure localisée partielle (figure 4) pour amincir l'épaisseur du silicium aux emplacements requis pour la réalisation du coupleur surfacique 8. A l'issue de l'opération 514, les régions amincies présentent une épaisseur inférieure à l'épaisseur e₁₂.

A l'inverse, lors de cette opération 514, d'autres régions dite « non-amincies », ne sont pas gravées et conservent leur épaisseur initiale. En particulier, ces régions non-amincies sont situées à l'emplacement de la partie basse 223 et à l'emplacement de l'électrode 130.

Lors d'une opération 516, une gravure totale localisée de la couche 43 est réalisée (figure 5). Contrairement à la gravure partielle, la gravure totale élimine complètement l'épaisseur de silicium de la couche 43 dans les régions non masquées où elle est appliquée. A l'inverse, des régions masquées protègent la couche 43 de cette gravure totale. Cette gravure totale est réalisée de manière à structurer, simultanément dans la couche 43, l'électrode 120, la partie basse 223 et le coupleur surfacique 8. A cet effet, seules les régions correspondant à ces différents éléments sont masquées. On obtient à l'issue de cette étape, l'état représenté sur la figure 5.

Lors d'une opération 518, des opérations de dopage localisé sont mises en œuvre pour obtenir les différents niveaux de dopage souhaités pour les extrémités proximale 11 et distale 12 de l'électrode 120. Ces opérations de dopage localisé étant classiques, celles-ci ne sont pas décrites ici. De préférence, le dopage de l'électrode 120 est un dopage P. Ici, il est obtenu par implantation ionique en Bore.

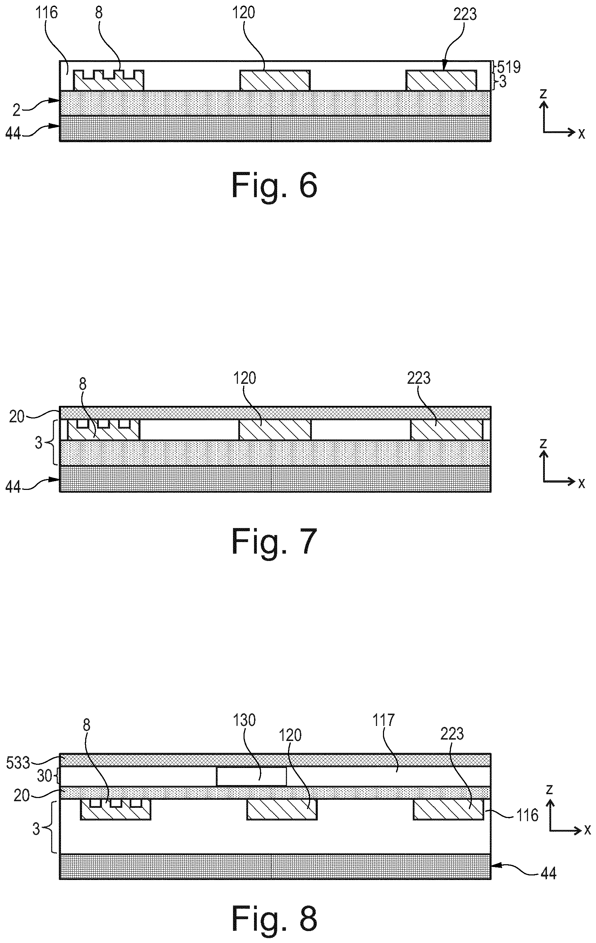

Lors d'une opération 520, la couche 43 de silicium monocristallin, qui a été structurée lors des étapes précédentes, est encapsulée dans le matériau diélectrique 116 (figure 6). A l'issue de l'opération 518, la couche 3 est obtenue. A ce stade, la couche 3 est recouverte d'une couche horizontal 519 en matériau diélectrique 116 dont l'épaisseur est supérieure à l'épaisseur e₂₀ de la couche 20.

Ensuite, lors d'une opération 522, la couche 519 est amincie pour obtenir la couche 20 située sur la couche 3 (Figure 7). Lors de l'opération 522, la face supérieure de la couche 20 est aussi préparée pour un collage, par exemple direct ou moléculaire, c'est-à-dire sans apport de matière. Par exemple, l'opération 522 est réalisée en polissant la face supérieure du matériau 116 par un procédé tel qu'un procédé de CMP (Chemical-Mechanical Polishing).

Ensuite, lors d'une étape 527, la couche 30 est fabriquée sur la couche 20.

Par exemple, lors d'une opération 528, l'électrode 130 est réalisée sur la face supérieure de la couche 20. Ici, l'électrode 130 est réalisée par collage direct d'une vignette ou d'un substrat en matériau III-V sur la couche 20 à l'emplacement où l'électrode 130 doit être réalisée. Ensuite, le matériau III-V collé est premièrement amincis par une séquence utilisant soit mécaniquement une meule (grinding) puis chimiquement par une solution sélective vis-à-vis d'une couche d'arrêt dans l'empilement III-V collé, soit uniquement de façon chimique. La couche de matériau III-V restante est ensuite structurée, par exemple par gravure sèche ou humide, pour obtenir l'électrode 130. La réalisation de l'électrode 130 par collage et structuration de matériau III-V est classique et n'est pas décrite ici plus en détail. Par exemple, le lecteur intéressé peut consulter les articles suivants pour des exemples de telles réalisations :
- H. Duprez et al. : "1310 nm hybrid InP/InGaAsP on silicon distributed feedback laser with high side-mode suppression ratio", Optic Express 23(7), pp. 8489-8497 (2015),
- J.-H. Han et al. : "Efficient low-loss InGaAsP/Si hybrid MOS optical modulator," Nature Photonics 11, pp. 486 (2017).

Lors d'une opération 532, l'électrode 130 est encapsulée dans le matériau diélectrique 117. On obtient alors la couche 30 recouverte d'une couche horizontale 533 (Figure 8) en matériau diélectrique dont l'épaisseur est supérieure à l'épaisseur e₃₂ de la couche 32.

Ensuite, lors d'une opération 534, la couche 533 est amincie pour obtenir l'épaisseur souhaitée de la couche 30. Par exemple, ici, l'épaisseur de la couche 30 est égale à l'épaisseur de l'électrode 130, c'est-à-dire égale à l'épaisseur e₃₂. Dans ce cas, à l'issue de l'opération 534, l'électrode 130 affleure sur la face supérieure de la couche 30 et la couche 533 est totalement éliminée. L'opération 534 est par exemple réalisée comme l'opération 522 précédemment décrite.

Ensuite, lors d'une étape 540, la partie haute 222 du guide d'onde 220 est fabriquée. Ici la partie haute 222 est formée en mettant en œuvre un procédé connu sous le nom de « Damascène ». Ce procédé est par exemple décrit en référence à la figure 3 de l'article suivant : P. Dong et al. : « Novel integration technique for silicon/III-V hybrid laser », Optics Express 22(22), Vol. 22, N°22, pp. 26861, 2014.

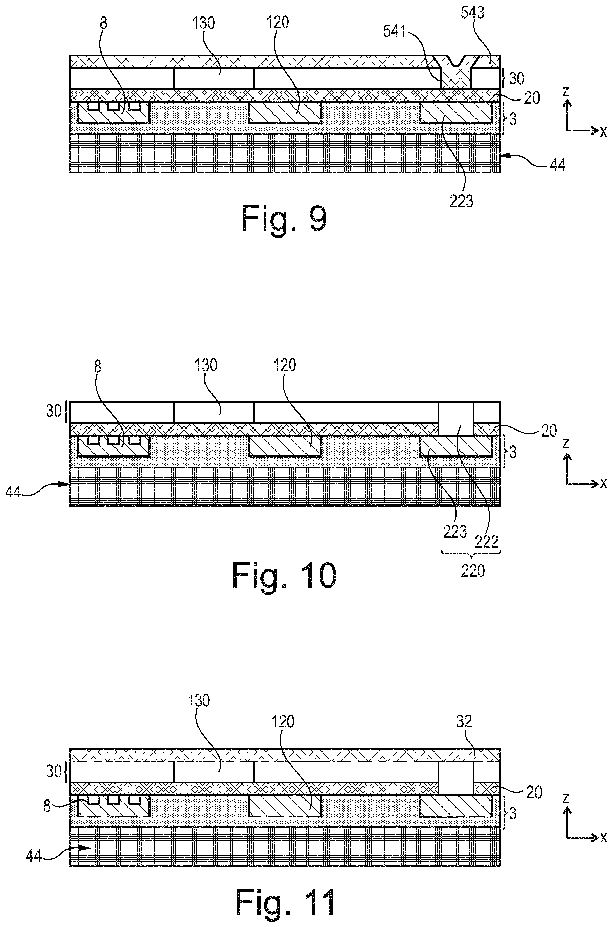

En résumé, il consiste à creuser une tranchée 541 (Figure 9) à l'emplacement où la partie haute 222 doit être réalisée. Dans cet exemple de réalisation, le fond de la tranchée débouche directement sur la partie basse 223. Ainsi, la tranchée 541 creusée traverse de part en part les couches 30 et 20. Ensuite, du silicium, ici du silicium amorphe 543, est déposé à l'intérieur de cette tranchée. Généralement, lors de cette opération, du silicium amorphe se dépose également sur la surface de la couche 30. Enfin, une opération de polissage permet de retirer l'excédent de silicium amorphe qui a été déposé au-dessus et/ou sur les côtés de la tranchée. On obtient alors l'état représenté sur la figure 10.

Ensuite, lors d'une étape 544, la couche 32 est réalisée sur la face supérieure de la couche 30. Par exemple, une couche en matériau diélectrique, d'épaisseur supérieure à l'épaisseur e₃₂, est directement déposée sur cette face supérieure. Ensuite, cette couche en matériau diélectrique est amincie pour obtenir la couche 32 située sur la couche 30 (Figure 11). L'étape 544 est par exemple réalisée comme décrit pour l'opération 522. La face supérieure de la couche 32 est ainsi aussi préparée pour un collage direct.

Lors d'une étape 546, la couche 36 est fabriquée sur la couche 32.

Lors d'une opération 548, le guide d'onde 200 est réalisé sur la face supérieure de la couche 32. Ici, le guide d'onde 200 est réalisé par collage direct d'un empilement en matériau III-V à gain. La réalisation du guide d'onde 200 par collage et structuration d'empilements de matériau III-V est classique et n'est pas décrit ici plus en détail. Par exemple, le lecteur intéressé peut consulter les articles suivants pour des exemples de telles réalisations :
- H. Duprez et al. : "1310 nm hybrid InP/InGaAsP on silicon distributed feedback laser with high side-mode suppression ratio", Optic Express 23(7), pp. 8489-8497 (2015),
- J.-H. Han et al. : "Efficient low-loss InGaAsP/Si hybrid MOS optical modulator," Nature Photonics 11, pp. 486 (2017).

Lors d'une opération 550, le guide d'onde 200 est encapsulé dans le matériau diélectrique 136. On obtient alors la couche 36 comportant le matériau à gain III-V encapsulé dans le matériau diélectrique 136.

Enfin, lors d'une étape 552, les prises de contact 21, 22, 243G et 243D sont réalisées. On obtient alors le transmetteur 5 tel que représenté sur la figure 1.

### Chapitre II : Variantes

### Variantes de l'électrode 120 :

Dans un autre mode de réalisation, l'électrode 120 comporte une partie intermédiaire située entre les extrémités proximale 12 et distale 11 et dont l'épaisseur est plus petite que l'épaisseur e₁₂. Cette partie intermédiaire est, par exemple, séparée de la couche 20 par un renfoncement remplit d'un matériau diélectrique. Typiquement, le renfoncement est rempli du matériau 116. Le fond de ce renfoncement est essentiellement horizontal et espacé de la couche 20 par une profondeur p₅₇₈. La profondeur p₅₇₈ est typiquement supérieure à 50 nm ou 100 nm. Cette conformation de la partie intermédiaire permet un meilleur contrôle de la largeur du guide d'onde 70. Une telle conformation de la partie intermédiaire et sa fabrication sont décrits dans la demande US2017237229A1. Elle n'est donc pas décrite ici plus en détail.

Dans une variante, le dopage de l'extrémité proximale 12 et de l'extrémité distale 11 sont les mêmes. Dès lors, lors de la fabrication de l'électrode 120, une seule étape de dopage de la couche 43 en silicium monocristallin est nécessaire.

L'électrode 120 peut aussi présenter un dopage N. Un tel dopage N est par exemple obtenu par implantation d'ion Phosphore. Dans ce cas, l'électrode 130 présente un dopage P.

L'électrode 120 peut être réalisée dans un autre matériau semi-conducteur. Par exemple, l'électrode 120 est réalisée en alliage SiGe ou par une superposition de couche en silicium et en alliage SiGe.

### Variantes de l'électrode 130 :

Le matériau III-V utilisé pour réaliser l'électrode 130 peut être différent. Par exemple, il peut s'agir de l'alliage InP, de l'alliage AsGa, de l'alliage InGaAsP, ou AlGaInAs ou d'une superposition de plusieurs de ces alliages. En particulier, l'électrode 130 peut être constituée d'un empilement InGaAsP/InP ou d'un empilement InP/InGaAsP/InP ou d'un empilement InGaAsP/InP/AlInAs.

Dans un autre mode de réalisation, l'électrode 130 est réalisée dans un matériau III-V différent de celui utilisé pour réaliser la bande 238.

En variante, à l'intérieur de la couche 30, le matériau cristallin III-V est confiné entre l'interface entre les couches 20 et 30 et un plan horizontal supérieur situé en-dessous de l'interface entre les couches 30 et 32. Dans ce cas, l'électrode 130 est séparée de la couche 32 par une épaisseur supplémentaire de matériau diélectrique 117. Cela permet, si nécessaire, de réduire l'épaisseur de l'électrode 130 par rapport à l'épaisseur de la partie 222 du guide d'onde 220. Par exemple, pour cela, lors de l'opération 534, la couche 533 n'est pas totalement éliminée.

L'épaisseur e₃₂ peut être choisie différemment. Par exemple, en variante, les épaisseurs e₁₂ et e₃₂, respectivement, des extrémités proximales 12 et 32, sont choisies pour que le point où se situe le maximum d'intensité du champ optique du signal optique qui se propage dans le guide d'onde 70, soit le plus près possible de l'épaisseur de matériau diélectrique située à l'intérieur de la portion 20B. De préférence, ce point M est situé au centre de l'épaisseur e₂₀ de matériau diélectrique de la portion 20B. En effet, c'est au niveau des interfaces entre les extrémités proximales 12, 32 et le matériau diélectrique de la portion 20B que la densité de porteurs de charges est maximale lorsqu'une différence de potentiels est présente entre les extrémités proximales 12 et 32. Cela améliore donc l'efficacité du modulateur 100. Par exemple, à cette fin, dans le cas où les indices de réfraction des extrémités proximales 12 et 32 sont proches l'un de l'autre, les épaisseurs e₁₂ et e₃₂ sont choisies sensiblement égales. Par exemple, l'épaisseur e₁₂ est comprise entre 0,5e₃₂ et 1,5e₃₂, et, de préférence, entre 0,7e₃₂ et 1,3e₃₂.

### Variantes du guide d'onde 220 :

La partie 223 du guide d'onde 220 peut être réalisée dans un autre matériau semi-conducteur. Par exemple, lorsque l'électrode 120 est réalisée en alliage SiGe ou par une superposition de couche en silicium et en alliage SiGe, la partie 223 est réalisée dans le même matériau semi-conducteur.

La partie haute 222 peut aussi être réalisée dans un autre matériau semi-conducteur que du silicium et, éventuellement, être réalisée dans un matériau semi-conducteur différent de celui utilisé pour réaliser la partie basse 223. Par exemple, en variante, la partie haute 222 est réalisée dans le même matériau que celui utilisé pour réaliser l'électrode 130. Dans ce cas, de préférence, la partie haute 222 est fabriquée et structurée en même temps et lors des mêmes opérations que celles mises en œuvre pour fabriquer l'électrode 130. Ainsi, la partie haute 222 est réalisée en matériau III-V rapporté par collage direct sur la couche 20. La partie haute 222 est donc séparée de la partie basse 223 par la couche 20. Étant donné que la couche 20 est très fine, cela ne modifie pas la capacité du guide d'onde 220 à guider efficacement le signal optique.

D'autres conformations du guide d'onde 220 sont possibles. Par exemple, en variante la largeur, dans la direction X, de la partie 223 est égale à la largeur de la partie 222. Dans ce cas, la conformation du guide d'onde 220 est connue sous le terme de "guide d'onde en bande" ou, en anglais, de "strip waveguide". Dans un autre mode de réalisation, la largeur, dans la direction X, de la partie 222 est plus grande que la largeur de la partie 223. Dans ce cas, la conformation du guide d'onde 220 est toujours un guide d'onde à arrête mais les positions de l'arrête et de la dalle sont inversées par rapport au mode de réalisation de la figure 1, En variante, la partie 223 du guide d'onde 220 est omise. Dans ce cas, le guide d'onde 220 est entièrement réalisé à l'intérieur des couches 20 et 30 ou seulement à l'intérieur de la couche 30.

### Autres variantes du modulateur :

Le modulateur 100 peut aussi être un modulateur en anneau. A cet effet, le guide d'onde 70 se referme sur lui-même pour former un guide d'onde annulaire dans lequel la densité des porteurs de charge peut être modifiée en fonction de la différence de potentiels appliquée entre les prises 21 et 22. Typiquement, ce guide d'onde annulaire est raccordé à un guide d'onde dans lequel se propage le signal optique à moduler par un couplage évanescent. Le guide d'onde 70 peut aussi constituer uniquement une portion limitée du guide d'onde annulaire.

Dans un autre mode de réalisation, le modulateur est utilisé pour moduler l'intensité du signal optique qui le traverse. En effet, une modification de la densité des porteurs de charge dans le guide d'onde 70 modifie également l'intensité du signal optique qui le traverse.

Dans une autre variante, la couche 20 est totalement éliminée là où elle n'est pas indispensable au fonctionnement du transmetteur. Par exemple, elle est totalement éliminée en dehors de la portion 20B.

Quel que soit le mode de réalisation, il est possible d'intervertir les régions dopées N et P.

### Variantes de la source laser:

Dans une variante, la couche 32 est totalement éliminée là où elle n'est pas indispensable au fonctionnement du transmetteur. Par exemple, elle est totalement éliminée en dehors de la portion 32A.

D'autres matériaux à gain III-V sont possibles pour réaliser la source laser 7. Par exemple, la couche 36 est formée de l'empilement suivant en allant du bas vers le haut :
- une sous-couche inférieure en GaAs dopée N,
- des sous-couches à boites quantiques en AIGaAs , ou des puits quantiques AlGaAs, et
- une sous-couche supérieure en GaAs dopée P.

### Variantes du procédé de fabrication :

L'étape 502 de réalisation des couches 3 et 20 peut comporter d'autres opérations de gravure. Par exemple, l'étape 502 comporte une opération de gravure supplémentaire pour amincir la partie basse 223 du guide d'onde 220 de la source laser. Dans ce cas, l'épaisseur e₂₂₃ est plus petite que l'épaisseur e₁₂ de l'électrode 120. Dans une autre variante, c'est l'électrode 120 qui est amincie pour obtenir une épaisseur e₁₂ plus petite que l'épaisseur e₂₂₃.

Dans une autre variante, l'opération 516 de gravure totale localisée est remplacée par une gravure uniforme de toute la surface de la couche 43 pour transformer les régions non-amincies en régions amincies et éliminer complètement les régions amincies.

L'opération 518 de dopage peut aussi être réalisée avant les opérations 514 et 516 de gravure. Dans un autre mode de réalisation, l'opération 518 est réalisée en même temps que l'une des opérations de gravure.

La couche diélectrique 20 peut être obtenue par des procédés de fabrication différents. Par exemple, lors de l'opération 522, la couche 519 est complètement retirée jusqu'à la couche 3 puis la couche 20 est déposée sur la couche 3 mise à nue. Dans ce cas, éventuellement, le matériau diélectrique de la couche 20 peut être différent du matériau 116. Par exemple, il peut s'agir d'un matériau diélectrique tel qu'un polymère électriquement isolant ou en Al₂O₃. Après le retrait complet de la couche 519, il est aussi possible de réaliser la couche 20 par oxydation de la surface de la couche 3.

Avant le collage de l'électrode 130, la couche 20 est réalisée sur la face inférieure de la vignette en matériau III-V cristallin. Par exemple, la couche 20 est obtenue par oxydation du matériau III-V ou par dépôt de diélectrique sur la face du matériau III-V à coller. Ensuite, la couche 20 formée sur la vignette en matériau III-V est collée, par collage direct, sur la face supérieure de la couche 3. Le procédé de fabrication du transmetteur 5 se poursuit alors par l'opération 528 de structuration de l'électrode 130 dans la vignette en matériau III-V collée sur la couche 3.

D'autres modes de réalisation de l'étape 540 de réalisation de la partie haute 222 sont possibles. Par exemple, la tranchée 541 ne débouche pas sur la partie basse 223 et le fond de la tranchée est située au niveau, par exemple, de l'interface entre les couches 20 et 30. Dans ce cas, la partie haute 222 est séparée mécaniquement de la partie basse par la couche 20. Toutefois, comme indiqué ci-dessus, étant donné que la couche 20 est très fine, cela n'altère en rien le fonctionnement du guide d'onde 220.

Dans une autre variante, la partie basse 223 n'est pas réalisée lors de l'étape 502 mais lors de l'étape 540. A cet effet, lors de l'étape 540, le fond de la tranchée est située à l'intérieur de la couche 3. Ainsi, dans ce cas, la partie haute 222 et la partie basse 223 sont réalisées en même temps lors du remplissage de la tranchée par du matériau semi-conducteur.

Le remplissage de la tranchée 541 peut être réalisé en mettant en œuvre d'autres procédés que le procédé Damascène. Par exemple, lorsque le fond de la tranchée 541 débouche sur la partie basse 223 en silicium monocristallin, la tranchée 541 peut être remplie par croissance épitaxiale de silicium monocristallin à partir de la partie basse 223.

### Autres variantes :

D'autres matériaux diélectriques sont possibles pour les matériaux 116, 117, 136 et les couches 20 et 32. Par exemple, il peut s'agir de nitrure de silicium, de nitrure d'Aluminium, d'un polymère électriquement isolant, de Al₂O₃. De plus, dans le cas des couches 20 et 32, son indice de réfraction n'est pas nécessairement inférieur à celui du silicium.

En variante, une partie ou la totalité des prises de contact sont réalisées, non pas à travers le matériau 136, mais à travers le substrat 44. Dans ce cas, par rapport à ce qui a été représenté sur les figures précédentes, une ou plusieurs prises de contact électrique émergent sous le substrat.

Le substrat 44 peut être réalisé dans d'autre matériau que du silicium.

En variante, les guides d'ondes 70, 220 sont incurvés. Dans ce cas, la conformation des différents éléments optiquement couplés à ces guides d'onde est adaptée au rayon de courbure de ces guides d'onde.

### Chapitre III : Avantages des modes de réalisation décrits

L'épaisseur de matériau diélectrique supérieure à 40 nm dans la portion 32A permet d'obtenir un couplage adiabatique entre le guide d'onde 220 et le guide d'onde 200 au lieu d'un couplage évanescent. Un couplage adiabatique est plus simple à réaliser qu'un couplage évanescent. Avantageusement, dans le cas d'un couplage adiabatique, il n'est pas nécessaire de structurer des pointes dans le guide d'onde 200 en matériau III-V. A l'inverse, dans le cas d'un couplage évanescent, des pointes doivent être structurées dans le guide d'onde 200. Or, la structuration de pointes dans un guide d'onde en matériau III-V est une opération complexe à réaliser, en fonction de son épaisseur et des orientations cristallines. Ainsi, le fait que l'épaisseur de matériau diélectrique entre les guides d'onde 200 et 220 soit supérieure à 40 nm simplifie la fabrication du transmetteur. En particulier, à cause de cela, le transmetteur 5 est plus simple à fabriquer que celui décrit dans la demande US2017237229A1.

Le fait que l'épaisseur de matériau diélectrique entre les deux électrodes 120 et 130 soit inférieure à 35 nm permet la réalisation d'un modulateur capacitif. Si l'épaisseur de matériau diélectrique entre les deux électrodes 120 et 130 était supérieure, seul un modulateur à électro-absorption ou EAM (« Electro-absorption Modulator ») serait réalisable. Or, les modulateurs capacitifs présentent une bande passante, c'est-à-dire une gamme de longueur d'onde utile, bien plus grande que les modulateurs à électro-absorption.

Le fait que les épaisseurs de matériau diélectrique entre les guides d'onde 200 et 220 et entre les électrodes 120 et 130 soient différentes, permet d'obtenir un transmetteur qui présente en même temps les différents avantages ci-dessus, c'est-à-dire d'être à la fois simple à fabriquer tout en intégrant sur un même substrat une source laser et un modulateur capacitif et tout en présentant à la fois pour la source laser et pour le modulateur capacitif des performances optimisées.

Les modulateurs capacitifs hybrides sont également avantageux par rapport aux modulateurs capacitifs non-hybrides, dans lesquels l'électrode 130 est aussi réalisée en silicium. En effet, les modulateurs capacitifs hybrides permettent d'obtenir des changements de phase dix fois à cent fois plus efficaces qu'un modulateur capacitif non-hybride. Ainsi, les transmetteurs décrits présentent des performances égales ou meilleures à celles du transmetteur de la demande US2017237229A1.

Les procédés de fabrication décrits ici permettent d'ajuster l'épaisseur du matériau diélectrique dans la portion 20A de la couche 20 indépendamment de l'épaisseur de matériau diélectrique dans la portion 32B de la couche 32. Les procédés décrits permettent donc de fabriquer sur le même substrat à la fois une source laser à semi-conducteur et un modulateur capacitif optimisés indépendamment l'un de l'autre.

Le procédé de fabrication décrit ici présente en particulier les avantages suivants :
- Il permet de contrôler l'épaisseur de la couche 20 indépendamment de l'épaisseur de la couche 32.
- Il n'est pas nécessaire de retourner le substrat 44 pour coller la couche 20 sur un autre substrat.
- Il permet de régler précisément l'épaisseur de l'électrode 120 indépendamment de l'épaisseur du guide d'onde 220 et, plus généralement, indépendamment de l'épaisseur de la couche 43 en silicium monocristallin. Ceci est particulièrement utile car, généralement, pour améliorer le fonctionnement de la source laser 7, il faut que l'épaisseur du guide d'onde 220 soit assez grande, c'est-à-dire ici de l'ordre de 500 nm. A l'inverse, pour améliorer le fonctionnement du modulateur 100, comme expliqué ci-dessus, l'épaisseur de l'électrode 120 et, en particulier de son extrémité proximale 12, est généralement inférieure à l'épaisseur e₂₂₂.
- Ce procédé permet d'éviter la formation d'une capacité parasite sous l'extrémité distale 31 et donc un fonctionnement plus rapide du modulateur 100.

## Revendications

1. Transmetteur photonique comportant :
- un empilement comportant un substrat (44) s'étendant principalement dans un plan appelé « plan du substrat » et les couches suivantes empilées successivement les unes au-dessus des autres et s'étendant chacune principalement parallèlement au plan du substrat :
• une première couche (3) située directement sur le substrat (44) et comportant un premier matériau semi-conducteur cristallin encapsulé dans un matériau diélectrique (116), ce premier matériau semi-conducteur cristallin étant choisi dans le groupe constitué du silicium monocristallin, de l'alliage SiGe et d'une superposition de silicium monocristallin et d'alliage SiGe,
• une deuxième couche (20) en matériau diélectrique située directement sur la première couche (3), l'épaisseur de cette deuxième couche étant comprise entre 5 nm et 35 nm,
• une troisième couche (30) située directement sur la deuxième couche (20) et comportant un second matériau semi-conducteur cristallin encapsulé dans un matériau diélectrique (117),
- une source laser (7) à semi-conducteur apte à générer un signal optique, cette source laser comportant un premier guide d'onde (220) et un deuxième guide d'onde (200) en matériau à gain III-V, les premier et deuxième guides d'onde étant couplés optiquement l'un à l'autre à travers une couche en matériau diélectrique,
- un modulateur (100) de phase et/ou d'amplitude réalisé sur le même substrat (44) et apte à moduler le signal optique généré par la source laser à semi-conducteur, ce modulateur comportant :
• une première électrode (120) dopée P ou N structurée dans le premier matériau semi-conducteur cristallin de la première couche (3),
• une seconde électrode (130) dopée structurée dans le second matériau semi-conducteur cristallin de la troisième couche, cette seconde électrode présentant un dopage de signe opposé à celui de la première électrode et étant séparée de la première électrode seulement par la deuxième couche (20),
**caractérisé en ce que** :
- l'empilement comporte :
• une quatrième couche (32) en matériau diélectrique située directement sur la troisième couche (30), cette quatrième couche formant ladite couche diélectrique à travers laquelle les premier et second guides d'onde de la source laser sont couplés optiquement l'un à l'autre, l'épaisseur de cette quatrième couche étant comprise entre 40 nm et 1 µm pour obtenir un couplage adiabatique entre les premier et second guides d'onde, et
• une cinquième couche (36) située directement sur la quatrième couche et comportant un matériau à gain III-V encapsulé dans un matériau diélectrique (136), le deuxième guide d'onde (200) de la source laser étant entièrement structuré dans le matériau à gain III-V de cette cinquième couche, et
- le premier guide d'onde (220) de la source laser comporte une première partie (222) en matériau semi-conducteur située à l'intérieur de la troisième couche (30) et qui s'étend, dans une direction perpendiculaire au plan du substrat, jusqu'à l'interface entre les troisième et quatrième couches.

2. Transmetteur selon la revendication 1, dans lequel :
- le second matériau semi-conducteur cristallin de la troisième couche (30) s'étend directement sur la deuxième couche (20),
- la première électrode (120) du modulateur s'étend, dans une direction transversale (X) parallèle au plan du substrat, depuis une extrémité proximale (12) jusqu'à une extrémité distale (11), et s'étendant longitudinalement dans la direction (Y) de propagation du signal optique,
- la seconde électrode (130) du modulateur s'étendant, dans la direction transversale (X), depuis une extrémité proximale (32) située en vis-à-vis de l'extrémité proximale (12) de la première électrode (120) jusqu'à une extrémité distale (31) située d'un côté opposé à l'extrémité distale (11) de la première électrode (120) par rapport à un plan perpendiculaire au plan du substrat et traversant les extrémités proximales (12, 32), cette seconde électrode (130) s'étendant longitudinalement également dans la direction (Y) de propagation du signal optique,
- le modulateur (100) comporte également des prises de contact (21, 22) directement en contact mécanique et électrique avec, respectivement, les extrémités distales (11, 31) des électrodes (120, 130) pour raccorder électriquement les première et seconde électrodes à des potentiels électriques différents de manière à modifier la densité de porteurs de charges à l'intérieur d'un troisième guide d'onde (70) formé par la superposition des extrémités proximales (12, 32) des électrodes et une portion (20B) de la deuxième couche (20) interposée entre ces extrémités proximales.

3. Transmetteur selon la revendication 2, dans lequel l'épaisseur maximale de l'extrémité proximale (12) de la seconde électrode est strictement inférieure à l'épaisseur maximale de la première partie (222) du premier guide d'onde (220).

4. Transmetteur selon la revendication 3, dans lequel le premier guide d'onde (220) de la source laser comporte aussi une seconde partie (223) structurée dans le premier matériau semi-conducteur cristallin de la première couche (3) et la première partie (220) traverse la deuxième couche (20) et s'étend, dans une direction perpendiculaire au plan du substrat, depuis la seconde partie (223) jusqu'à l'interface entre les troisième et quatrième couches.

5. Transmetteur selon la revendication 3 ou 4, dans lequel l'épaisseur maximale de l'extrémité proximale (32) de la seconde électrode (130) est comprise entre 0,7e₁₂ et 1,3e₁₂, où e₁₂ est l'épaisseur maximale de l'extrémité proximale (12) de la première électrode (120).

6. Transmetteur selon l'une quelconque des revendications précédentes, dans lequel le second matériau semi-conducteur cristallin est un matériau cristallin III-V et, de préférence, un matériau cristallin III-V choisi dans le groupe constitué de l'alliage InP, de l'alliage AsGa, de l'alliage InGaAsP ou par une superposition de plusieurs des alliages de groupe.

7. Transmetteur selon l'une quelconque des revendications 2 à 6, dans lequel le modulateur comporte une zone (34) uniquement composée d'un ou plusieurs matériaux diélectriques solides (116) qui s'étend :
- dans la direction perpendiculaire au plan du substrat, depuis l'extrémité distale (31) de la seconde électrode jusqu'au substrat (44), et
- dans la direction transversale (X) et dans la direction (Y) de propagation du signal optique, sous la totalité de l'extrémité distale (31) de la seconde électrode (130).

8. Procédé de fabrication d'un transmetteur photonique à semi-conducteur conforme à l'une quelconque des revendications précédentes, ce procédé comportant :
- la réalisation (502, 527, 544, 546) d'un empilement comportant un substrat (44) s'étendant principalement dans un plan appelé « plan du substrat » et les couches suivantes empilées successivement les unes au-dessus des autres et s'étendant chacune principalement parallèlement au plan du substrat :
• une première couche (3) située directement sur le substrat comportant un premier matériau semi-conducteur cristallin encapsulé dans un matériau diélectrique (116), ce premier matériau semi-conducteur cristallin étant choisi dans le groupe constitué du silicium monocristallin, de l'alliage SiGe et d'une superposition de silicium monocristallin et d'alliage SiGe,
• une deuxième couche (20) en matériau diélectrique située directement sur la première couche (3), l'épaisseur de cette deuxième couche étant comprise entre 5 nm et 35 nm,
• une troisième couche (30) située directement sur la deuxième couche (20) et comportant un second matériau semi-conducteur cristallin encapsulé dans un matériau diélectrique (117),
- la réalisation (540, 544, 546) d'une source laser (7) à semi-conducteur apte à générer un signal optique, cette source laser comportant un premier guide d'onde (220) et un deuxième guide d'onde (200) en matériau à gain III-V, les premier et deuxième guides d'onde étant couplés optiquement l'un à l'autre à travers une couche en matériau diélectrique,
- la réalisation (502, 527, 527) d'un modulateur (100) de phase et/ou d'amplitude réalisé sur le même substrat (44) et apte à moduler le signal optique généré par la source laser à semi-conducteur, ce modulateur comportant :
• une première électrode (120) dopée P ou N structurée dans le premier matériau semi-conducteur cristallin de la première couche (3),
• une seconde électrode (130) dopée structurée dans le second matériau semi-conducteur cristallin de la troisième couche (30), cette seconde électrode présentant un dopage de signe opposé à celui de la première électrode et étant séparée de la première électrode seulement par la deuxième couche (20),
**caractérisé en ce que**:
- la réalisation de l'empilement comporte :
• la réalisation (544) d'une quatrième couche (32) en matériau diélectrique située directement sur la troisième couche (30), cette quatrième couche formant ladite couche diélectrique à travers laquelle les premier et second guides d'onde de la source laser sont couplés optiquement l'un à l'autre, l'épaisseur de cette quatrième couche étant comprise entre 40 nm et 1 µm pour obtenir un couplage adiabatique entre les premier et second guides d'onde, et
• la réalisation (546) d'une cinquième couche (36) située directement sur la quatrième couche et comportant un matériau à gain III-V encapsulé dans un matériau diélectrique, le deuxième guide d'onde de la source laser étant entièrement structuré dans le matériau à gain III-V de cette cinquième couche, et
- la réalisation de la source laser comporte la réalisation (540) d'une première partie (222) du premier guide d'onde en matériau semi-conducteur et située à l'intérieur de la troisième couche (30) et qui s'étend, dans une direction perpendiculaire au plan du substrat, jusqu'à l'interface entre les troisième et quatrième couches.

9. Procédé selon la revendication 8, dans lequel la réalisation (540) de la première partie du premier guide d'onde comporte :
- à l'emplacement de cette première partie dans la troisième couche, la réalisation dans la troisième couche d'une tranchée dont la profondeur est supérieure ou égale à l'épaisseur de la seconde électrode du modulateur, puis
- le remplissage de la tranchée avec du matériau semi-conducteur pour former la première partie du premier guide d'onde.

10. Procédé selon la revendication 8 ou 9, dans lequel la réalisation du premier guide d'onde (220) de la source laser comporte :
- la gravure (514, 516) du premier matériau semi-conducteur cristallin de la première couche pour délimiter, en mème temps, la première électrode du modulateur et une seconde partie du premier guide d'onde de la source laser, puis
- l'encapsulation (520) du premier matériau semi-conducteur cristallin ainsi gravé dans un matériau diélectrique pour obtenir la première couche.

## Patentansprüche

1. Photonischer Sender, der Folgendes umfasst:
- einen Stapel, der ein Substrat (44), das sich im Wesentlichen in einer Ebene, die als "Substratebene" bezeichnet wird, erstreckt, und die folgenden Schichten umfasst, die nacheinander übereinander gestapelt sind und sich jeweils im Wesentlichen parallel zu der Substratebene erstrecken:
• eine erste Schicht (3), die sich direkt auf dem Substrat (44) befindet und ein erstes kristallines Halbleitermaterial umfasst, das in einem dielektrischen Material (116) verkapselt ist, wobei dieses erste kristalline Halbleitermaterial aus der Gruppe ausgewählt ist, die aus monokristallinem Silizium, einer SiGe-Legierung und einer Übereinanderschichtung von monokristallinem Silizium und einer SiGe-Legierung besteht,
• eine zweite Schicht (20) aus einem dielektrischen Material, die sich direkt auf der ersten Schicht (3) befindet, wobei die Dicke dieser zweiten Schicht zwischen 5 nm und 35 nm liegt,
• eine dritte Schicht (30), die sich direkt auf der zweiten Schicht (20) befindet und ein zweites kristallines Halbleitermaterial umfasst, das in einem dielektrischen Material (117) verkapselt ist,
- eine Halbleiterlaserquelle (7), die dazu fähig ist, ein optisches Signal zu erzeugen, wobei diese Laserquelle einen ersten Wellenleiter (220) und einen zweiten Wellenleiter (200) aus einem III-V-Verstärkungsmaterial umfasst, wobei der erste und der zweite Wellenleiter mittels einer Schicht aus dielektrischem Material optisch miteinander gekoppelt sind,
- einen Phasen- und/oder Amplitudenmodulator (100), der auf demselben Substrat (44) hergestellt ist und dazu fähig ist, das durch die Halbleiterlaserquelle erzeugte optische Signal zu modulieren, wobei dieser Modulator Folgendes umfasst:
• eine erste p- oder n-dotierte Elektrode (120), die in dem ersten kristallinen Halbleitermaterial der ersten Schicht (3) strukturiert ist,
• eine zweite dotierte Elektrode (130), die in dem zweiten kristallinen Halbleitermaterial der dritten Schicht strukturiert ist, wobei diese zweite Elektrode eine Dotierung aufweist, deren Vorzeichen zu dem der ersten Elektrode umgekehrt ist, und nur durch die zweite Schicht (20) von der ersten Elektrode getrennt ist,
**dadurch gekennzeichnet, dass**:
- der Stapel Folgendes umfasst:
• eine vierte Schicht (32) aus einem dielektrischen Material, die sich direkt auf der dritten Schicht (30) befindet, wobei diese vierte Schicht die dielektrische Schicht bildet, mittels derer der erste und der zweite Wellenleiter der Laserquelle optisch miteinander gekoppelt sind, wobei die Dicke dieser vierten Schicht zwischen 40 nm und 1 µm liegt, um eine adiabatische Kopplung zwischen dem ersten und dem zweiten Wellenleiter zu erhalten, und
• eine fünfte Schicht (36), die sich direkt auf der vierten Schicht befindet und ein III-V-Verstärkungsmaterial umfasst, das in einem dielektrischen Material (136) verkapselt ist, wobei der zweite Wellenleiter (200) der Laserquelle vollständig in dem III-V-Verstärkungsmaterial dieser fünften Schicht strukturiert ist, und
- der erste Wellenleiter (220) der Laserquelle einen ersten Abschnitt (222) aus Halbleitermaterial umfasst, der sich innerhalb der dritten Schicht (30) befindet und der sich in einer zu der Substratebene senkrechten Richtung bis zu der Schnittstelle zwischen der dritten und der vierten Schicht erstreckt.

2. Sender nach Anspruch 1, wobei:
- sich das zweite kristalline Halbleitermaterial der dritten Schicht (30) direkt auf der zweiten Schicht (20) erstreckt,
- sich die erste Elektrode (120) des Modulators in einer zu der Substratebene parallelen Querrichtung (X) von einem proximalen Ende (12) bis zu einem distalen Ende (11) erstreckt und sich längs in der Ausbreitungsrichtung (Y) des optischen Signals erstreckt,
- sich die zweite Elektrode (130) des Modulators in der Querrichtung (X) von einem proximalen Ende (32), das sich gegenüber dem proximalen Ende (12) der ersten Elektrode (120) befindet, bis zu einem distalen Ende (31) erstreckt, das sich bezogen auf eine zu der Substratebene senkrechten Ebene auf einer dem distalen Ende (11) der ersten Elektrode (120) entgegengesetzten Seite befindet und durch die proximalen Enden (12, 32) hindurchführt, wobei sich diese zweite Elektrode (130) längs ebenfalls in der Ausbreitungsrichtung (Y) des optischen Signals erstreckt,
- der Modulator (100) ferner Kontaktstellen (21, 22) umfasst, die in direktem mechanischen und elektrischen Kontakt mit den jeweiligen distalen Enden (11, 31) der Elektroden (120, 130) stehen, um die erste und die zweite Elektrode elektrisch mit unterschiedlichen elektrischen Potentialen zu verbinden, um die Ladungsträgerdichte im Inneren eines dritten Wellenleiters (70) zu verändern, der durch die Übereinanderschichtung der proximalen Enden (12, 32) der Elektroden und eines Abschnitts (20B) der zweiten Schicht (20), der zwischen diesen proximalen Enden eingefügt ist, gebildet ist.

3. Sender nach Anspruch 2, wobei die maximale Dicke des proximalen Endes (12) der zweiten Elektrode in jedem Fall kleiner als die maximale Dicke des ersten Abschnitts (222) des ersten Wellenleiters (220) ist.

4. Sender nach Anspruch 3, wobei der erste Wellenleiter (220) der Laserquelle ferner einen zweiten Abschnitt (223) umfasst, der in dem ersten kristallinen Halbleitermaterial der ersten Schicht (3) strukturiert ist, und der erste Abschnitt (220) durch die zweite Schicht (20) hindurchführt und sich in einer zu der Substratebene senkrechten Richtung von dem zweiten Abschnitt (223) bis zu der Schnittstelle zwischen der dritten und der vierten Schicht erstreckt.

5. Sender nach Anspruch 3 oder 4, wobei die maximale Dicke des proximalen Endes (32) der zweiten Elektrode (130) zwischen 0,7e₁₂ und 1,3e₁₂ liegt, wobei e₁₂ die maximale Dicke des proximalen Endes (12) der ersten Elektrode (120) ist.

6. Sender nach einem der vorhergehenden Ansprüche, wobei das zweite kristalline Halbleitermaterial ein kristallines III-V-Material ist und vorzugsweise ein kristallines III-V-Material ist, das aus der Gruppe ausgewählt ist, die aus einer InP-Legierung, einer AsGa-Legierung, einer InGaAsP-Legierung oder einer Übereinanderschichtung mehrerer der Gruppenlegierungen besteht.

7. Sender nach einem der Ansprüche 2 bis 6, wobei der Modulator einen Bereich (34) umfasst, der ausschließlich aus einem oder mehreren festen dielektrischen Materialien (116) besteht und der sich folgendermaßen erstreckt:
- in der zu der Substratebene senkrechten Richtung, von dem distalen Ende (31) der zweiten Elektrode bis zu dem Substrat (44), und
- in der Querrichtung (X) und in der Ausbreitungsrichtung (Y) des optischen Signals, unter der Gesamtheit des distalen Endes (31) der zweiten Elektrode (130).

8. Verfahren zur Fertigung eines photonischen Halbleitersenders nach einem der vorhergehenden Ansprüche, wobei dieses Verfahren Folgendes umfasst:
- Herstellen (502, 527, 544, 546) eines Stapels, der ein Substrat (44), das sich im Wesentlichen in einer Ebene, die als "Substratebene" bezeichnet wird, erstreckt, und die folgenden Schichten umfasst, die nacheinander übereinander gestapelt sind und sich jeweils im Wesentlichen parallel zu der Substratebene erstrecken:
• eine erste Schicht (3), die sich direkt auf dem Substrat befindet und ein erstes kristallines Halbleitermaterial umfasst, das in einem dielektrischen Material (116) verkapselt ist, wobei dieses erste kristalline Halbleitermaterial aus der Gruppe ausgewählt ist, die aus monokristallinem Silizium, einer SiGe-Legierung und einer Übereinanderschichtung von monokristallinem Silizium und einer SiGe-Legierung besteht,
• eine zweite Schicht (20) aus einem dielektrischen Material, die sich direkt auf der ersten Schicht (3) befindet, wobei die Dicke dieser zweiten Schicht zwischen 5 nm und 35 nm liegt,
• eine dritte Schicht (30), die sich direkt auf der zweiten Schicht (20) befindet und ein zweites kristallines Halbleitermaterial umfasst, das in einem dielektrischen Material (117) verkapselt ist,
- Herstellen (540, 544, 546) einer Halbleiterlaserquelle (7), die dazu fähig ist, ein optisches Signal zu erzeugen, wobei diese Laserquelle einen ersten Wellenleiter (220) und einen zweiten Wellenleiter (200) aus einem III-V-Verstärkungsmaterial umfasst, wobei der erste und der zweite Wellenleiter mittels einer Schicht aus dielektrischem Material optisch miteinander gekoppelt sind,
- Herstellen (502, 527, 527) eines Phasen- und/oder Amplitudenmodulators (100), der auf demselben Substrat (44) hergestellt ist und dazu fähig ist, das durch die Halbleiterlaserquelle erzeugte optische Signal zu modulieren, wobei dieser Modulator Folgendes umfasst:
• eine erste p- oder n-dotierte Elektrode (120), die in dem ersten kristallinen Halbleitermaterial der ersten Schicht (3) strukturiert ist,
• eine zweite dotierte Elektrode (130), die in dem zweiten kristallinen Halbleitermaterial der dritten Schicht (30) strukturiert ist, wobei diese zweite Elektrode eine Dotierung aufweist, deren Vorzeichen zu dem der ersten Elektrode umgekehrt ist, und nur durch die zweite Schicht (20) von der ersten Elektrode getrennt ist,
**dadurch gekennzeichnet, dass**:
- das Herstellen des Stapels Folgendes umfasst:
• Herstellen (544) einer vierten Schicht (32) aus einem dielektrischen Material, die sich direkt auf der dritten Schicht (30) befindet, wobei diese vierte Schicht die dielektrische Schicht bildet, mittels derer der erste und der zweite Wellenleiter der Laserquelle optisch miteinander gekoppelt sind, wobei die Dicke dieser vierten Schicht zwischen 40 nm und 1 µm liegt, um eine adiabatische Kopplung zwischen dem ersten und dem zweiten Wellenleiter zu erhalten, und
• Herstellen (546) einer fünften Schicht (36), die sich direkt auf der vierten Schicht befindet und ein III-V-Verstärkungsmaterial umfasst, das in einem dielektrischen Material verkapselt ist, wobei der zweite Wellenleiter der Laserquelle vollständig in dem III-V-Verstärkungsmaterial dieser fünften Schicht strukturiert ist, und
- das Herstellen der Laserquelle das Herstellen (540) eines ersten Abschnitts (222) des ersten Wellenleiters aus einem Halbleitermaterial umfasst, der sich innerhalb der dritten Schicht (30) befindet und der sich in einer zu der Substratebene senkrechten Richtung bis zu der Schnittstelle zwischen der dritten und der vierten Schicht erstreckt.

9. Verfahren nach Anspruch 8, wobei das Herstellen (540) des ersten Abschnitts des ersten Wellenleiters Folgendes umfasst:
- an der Stelle dieses ersten Abschnitts in der dritten Schicht, Herstellen, in der dritten Schicht, eines Grabens, dessen Tiefe größer als oder gleich der Dicke der zweiten Elektrode des Modulators ist, dann
- Füllen des Grabens mit Halbleitermaterial, um den ersten Abschnitt des ersten Wellenleiters zu bilden.

10. Verfahren nach Anspruch 8 oder 9, wobei das Herstellen des ersten Wellenleiters (220) der Laserquelle Folgendes umfasst:
- Ätzen (514, 516) des ersten kristallinen Halbleitermaterials der ersten Schicht, um gleichzeitig die erste Elektrode des Modulators und einen zweiten Abschnitt des ersten Wellenleiters der Laserquelle abzugrenzen, dann
- Verkapseln (520) des so geätzten ersten kristallinen Halbleitermaterials in einem dielektrischen Material, um die erste Schicht zu erhalten.

## Claims

1. Photonic transmitter, comprising:
- a stack comprising a substrate (44) mainly extending in a plane called the "plane of the substrate" and the following layers successively stacked one on top of the other and each extending mainly parallel to the plane of the substrate:
• a first layer (3) located directly on the substrate (44) and comprising a first crystalline semiconductor encapsulated in a dielectric material (116), this first crystalline semiconductor being chosen from the group consisting of single-crystal silicon, the alloy SiGe and a superposition of single-crystal silicon and SiGe alloy,
• a second layer (20) made of dielectric material located directly on the first layer (3), the thickness of this second layer being comprised between 5 nm and 35 nm,
• a third layer (30) located directly on the second layer (20) and comprising a second crystalline semiconductor encapsulated in a dielectric material (117),
- a semiconductor laser source (7) able to generate an optical signal, this laser source comprising a first waveguide (220) and a second waveguide (200) made of III-V gain medium, the first and second waveguides being optically coupled to each other through a layer made of dielectric material,
- a phase and/or amplitude modulator (100) produced on the same substrate (44) and able to modulate the optical signal generated by the semiconductor laser source, this modulator comprising:
• a p- or n-doped first electrode (120) structured in the first crystalline semiconductor of the first layer (3),
• a doped second electrode (130) structured in the second crystalline semiconductor of the third layer, this second electrode being doped with dopants of opposite type to that of the first electrode and being separated from the first electrode only by the second layer (20),
**characterized in that**:
- the stack comprises:
• a fourth layer (32) made of dielectric material located directly on the third layer (30), this fourth layer forming said dielectric layer through which the first and second waveguides of the laser source are optically coupled to each other, the thickness of this fourth layer being comprised between 40 nm and 1 µm in order to obtain an adiabatic coupling between the first and second waveguides, and
• a fifth layer (36) located directly on the fourth layer and comprising a III-V gain medium encapsulated in a dielectric material (136), the second waveguide (200) of the laser source being entirely structured in the III-V gain medium of this fifth layer, and
- the first waveguide (220) of the laser source comprises a first portion (222) made of semiconductor located inside the third layer (30) and that extends, in a direction perpendicular to the plane of the substrate, as far as to the interface between the third and fourth layers.

2. Transmitter according to Claim 1, wherein:
- the second crystalline semiconductor of the third layer (30) extends directly over the second layer (20),
- the first electrode (120) of the modulator extends, in a transverse direction (X) parallel to the plane of the substrate, from a near end (12) to a far end (11), and extends longitudinally in the direction (Y) of propagation of the optical signal,
- the second electrode (130) of the modulator extends, in the transverse direction (X), from a near end (32) located facing the near end (12) of the first electrode (120) to a far end (31) located on a side opposite the far end (11) of the first electrode (120) with respect to a plane perpendicular to the plane of the substrate and passing through the near ends (12, 32), this second electrode (130) also extending longitudinally in the direction (Y) of propagation of the optical signal,
- the modulator (100) also comprises contacts (21, 22) making direct mechanical and electrical contact with the far ends (11, 31) of the electrodes (120, 130), respectively, with a view to electrically connecting the first and second electrodes to different electrical potentials so as to modify the charge carrier density inside a third waveguide (70) formed by the superposition of the near ends (12, 32) of the electrodes and a segment (20B) of the second layer (20) interposed between these near ends.

3. Transmitter according to Claim 2, wherein the maximum thickness of the near end (12) of the second electrode is strictly smaller than the maximum thickness of the first portion (222) of the first waveguide (220).

4. Transmitter according to Claim 3, wherein the first waveguide (220) of the laser source also comprises a second portion (223) structured in the first crystalline semiconductor of the first layer (3) and the first portion (220) passes through the second layer (20) and extends, in a direction perpendicular to the plane of the substrate, from the second portion (223) to the interface between the third and fourth layers.

5. Transmitter according to Claim 3 or 4, wherein the maximum thickness of the near end (32) of the second electrode (130) is comprised between 0.7e₁₂ and 1.3e₁₂, where e₁₂ is the maximum thickness of the near end (12) of the first electrode (120).

6. Transmitter according to any one of the preceding claims, wherein the second crystalline semiconductor is a III-V crystalline semiconductor and, preferably, a III-V crystalline semiconductor chosen from the group consisting of the alloy InP, the alloy GaAs, the alloy InGaAsP, or a superposition of a plurality of the alloys of this group.

7. Transmitter according to any one of Claims 2 to 6, wherein the modulator comprises a region (34) composed solely of one or more solid dielectric materials (116), which extends:
- in the direction perpendicular to the plane of the substrate, from the far end (31) of the second electrode to the substrate (44), and
- in the transverse direction (X) and in the direction (Y) of propagation of the optical signal, under the entirety of the far end (31) of the second electrode (130).

8. Process for fabricating a semiconductor photonic transmitter according to any one of the preceding claims, this process comprising:
- producing (502, 527, 544, 546) a stack comprising a substrate (44) mainly extending in a plane called the "plane of the substrate" and the following layers successively stacked one on top of the other and each extending mainly parallel to the plane of the substrate:
• a first layer (3) located directly on the substrate and comprising a first crystalline semiconductor encapsulated in a dielectric material (116), this first crystalline semiconductor being chosen from the group consisting of single-crystal silicon, the alloy SiGe and a superposition of single-crystal silicon and SiGe alloy,
• a second layer (20) made of dielectric material located directly on the first layer (3), the thickness of this second layer being comprised between 5 nm and 35 nm,
• a third layer (30) located directly on the second layer (20) and comprising a second crystalline semiconductor encapsulated in a dielectric material (117),
- producing (540, 544, 546) a semiconductor laser source (7) able to generate an optical signal, this laser source comprising a first waveguide (220) and a second waveguide (200) made of III-V gain medium, the first and second waveguides being optically coupled to each other through a layer made of dielectric material,
- producing (502, 527, 527) a phase and/or amplitude modulator (100) produced on the same substrate (44) and able to modulate the optical signal generated by the semiconductor laser source, this modulator comprising:
• a p- or n-doped first electrode (120) structured in the first crystalline semiconductor of the first layer (3),
• a doped second electrode (130) structured in the second crystalline semiconductor of the third layer (30), this second electrode being doped with dopants of opposite type to that of the first electrode and being separated from the first electrode only by the second layer (20),
**characterized in that**:
- producing the stack comprises:
• producing (544) a fourth layer (32) made of dielectric material located directly on the third layer (30), this fourth layer forming said dielectric layer through which the first and second waveguides of the laser source are optically coupled to each other, the thickness of this fourth layer being comprised between 40 nm and 1 µm in order to obtain an adiabatic coupling between the first and second waveguides, and
• producing (546) a fifth layer (36) located directly on the fourth layer and comprising a III-V gain medium encapsulated in a dielectric material, the second waveguide of the laser source being entirely structured in the III-V gain medium of this fifth layer, and
- producing the laser source comprises producing (540) a first portion (222) of the first waveguide, this portion being made of semiconductor and located inside the third layer (30) and extending, in a direction perpendicular to the plane of the substrate, as far as to the interface between the third and fourth layers.

9. Process according to Claim 8, wherein producing (540) the first portion of the first waveguide comprises:
- in the location of this first portion in the third layer, producing, in the third layer, a trench the depth of which is larger than or equal to the thickness of the second electrode of the modulator, then
- filling the trench with the semiconductor to form the first portion of the first waveguide.

10. Process according to Claim 8 or 9, wherein producing the first waveguide (220) of the laser source comprises:
- etching (514, 516) the first crystalline semiconductor of the first layer to define, at the same time, the first electrode of the modulator and a second portion of the first waveguide of the laser source, then
- encapsulating (520) the first crystalline semiconductor thus etched in a dielectric material to obtain the first layer.
